Europäisches Patentamt

European Patent Office

Office européen des brevets

(19)

(11) Publication number: **0 326 432**
**A2**

## EUROPEAN PATENT APPLICATION

(21) Application number: 89300862.3

(22) Date of filing: 30.01.89

(51) Int. Cl.⁴: **H 01 L 29/32**
**H 01 L 21/322**
**// H01L27/10, H01L27/14**

(30) Priority: 29.01.88 JP 20476/88

(43) Date of publication of application:
02.08.89 Bulletin 89/31

(84) Designated Contracting States: **DE FR GB**

(71) Applicant: **SHARP KABUSHIKI KAISHA**
**22-22 Nagaike-cho Abeno-ku**
**Osaka 545 (JP)**

(72) Inventor: **Ishihama, Akira**
**8-36, Aoyama**
**Nara-shi Nara-ken (JP)**

(74) Representative: **Ranson, Arthur Terence et al**
**W.P. Thompson & Co. Coopers Building Church Street**
**Liverpool L1 3AB (GB)**

The title of the invention has been amended (Guidelines for Examination in the EPO, A-III, 7.3).

(54) Semiconductor device having a defect-containing zone in the substrate.

(57) A semiconductor device comprises a semiconductor substrate (1) which has a defect-containing zone (1a) in the inside thereof and a defect-free zone (1b) in the surface region thereof, wherein said defect-free zone (1b) is thinner within inactive areas (B) than within active areas (A).

EP 0 326 432 A2

## Description

## A SEMICONDUCTOR DEVICE

This invention relates to a semiconductor device and more particularly to a semiconductor device in which a defect-containing zone is intentionally formed in the inside of the semiconductor substrate thereof to prevent adverse effects of undesirable carriers on semiconductor elements formed in the surface region of the substrate.

In general, the generation of undesirable carriers in a semiconductor substrate has adverse effects on semiconductor elements formed in the substrate. For example, in a charge coupled device (CCD), undesirable carriers, which are generated by stray light incident from the periphery of the device, by impact ionization at the peripheral circuit, etc., are responsible for a variable output power level. In a dynamic random access memory (dynamic RAM), undesirable carriers, which are generated by alpha rays, etc., give rise to errors in the stored data.

As a method for preventing adverse effects of such undesirable carriers, there has been employed an intrinsic gettering method. According to the intrinsic gettering method, by heat treatment of a semiconductor substrate, microscopic defects due to oxygen contained therein are intentionally formed in the inside of the substrate, resulting in a defect-containing zone. On the other hand, there are no defects in the surface region of the substrate, resulting in a defect-free zone. Thus, recombination of undesirable carriers which have adverse effects on semiconductor elements formed in the substrate is allowed to occur within the defect-containing zone. Therefore, if the semiconductor elements are formed in the defect-free zone at the surface region of the substrate, it is possible to prevent the adverse effects of undesirable carriers generated in the deep region of the substrate.

However, when such an intrinsic gettering method is employed, the defect-free zone formed in the surface region of the semiconductor substrate has a uniform thickness both within the active areas and within the inactive areas of the substrate, wherein the semiconductor elements will be later formed within the active areas of the substrate. For this reason, in conventional devices, it is possible to prevent the adverse effects of undesirable carriers generated in the deep region of the substrate, whereas it is not possible to prevent the adverse effects of undesirable carriers generated in the surface region within the inactive areas of the substrate.

Moreover, in the case of epitaxial wafers which are usually used to prevent adverse effects of undesirable carriers, a defect-free zone is formed to have an uniform thickness throughout its entire region thereof, so that it is not possible to prevent adverse effects of undesirable carriers generated in the surface region within the inactive areas of the substrate.

The semiconductor device of this invention, which aims to overcome the above-discussed and numerous other disadvantages and deficiencies of the prior art, comprises a semiconductor substrate which has a defect-containing zone in the inside thereof and a defect-free zone in the surface region thereof, wherein the defect-free zone is thinner within inactive areas than within active areas.

In a preferred embodiment, semiconductor elements are formed in the defect-free zone of the substrate within the active areas.

In a preferred embodiment, the semiconductor device is selected from the group consisting of charge coupled devices, image sensors, and dynamic random access memories.

Thus, the invention described herein makes possible the objective of providing semiconductor devices, in which it is possible to prevent adverse effects of undesirable carriers generated in the surface region within the inactive areas of the substrate as well as adverse effects of undesirable carriers generated in the deep region of the substrate, such as CCD line image sensors with a constant output power level between respective channels thereof, CCD area image sensors with a constant output power level between respective picture elements thereof, and dynamic RAMs with few errors in the stored data.

By way of example only, a specific embodiment of the present invention will now be described, with reference to the accompanying drawings, in which:

Figure 1 is a partial view in vertical section of a substrate which is used for semiconductor devices of this invention.

Figure 2 is a partial view in vertical section of the substrate which is subjected to the first heat treatment.

Figure 3 is a graph showing the oxygen concentration distribution in the substrate after the first heat treatment.

Figure 4 is a partial view in vertical section of the substrate which is subjected to the second heat treatment.

Figure 5 is a graph showing the oxygen concentration distributions in the substrate after the second heat treatment.

The semiconductor substrate used for the semiconductor devices of this invention is prepared, for example, as follows:

First, by heat treatment at a high temperature for a short period of time, oxygen contained in the entire surface region of the semiconductor substrate is allowed to diffuse outwardly. Secondly, on the surface in the inactive areas of the substrate, a barrier film is formed to prevent the diffusion of oxygen contained in these areas, and the substrate is subjected to heat treatment at a high temperature for a long period of time, so that oxygen contained in the deep region within the active areas of the substrate is allowed to diffuse outwardly. Finally, the substrate is further heat-treated at a low temperature to form oxygen deposits in the inside of the substrate, so that the portion into which oxygen has diffused outwardly becomes a defect-containing zone. On the other hand, in the surface region of the substrate, a defect-free zone is formed which is thicker within the active areas than within the inactive areas of the substrate.

The semiconductor substrate obtained in this way is then provided with various semiconductor elements. Because the defect-free zone of large thickness has been formed in the active areas, the semiconductor elements can be formed in the same way as in the conventional semiconductor devices. Moreover, because the defect-containing zone has been formed up to the vicinity of the substrate surface in the inactive areas, it is possible to prevent the generation of undesirable carriers in these areas.

The invention will be further illustrated by reference to the following example.

Example

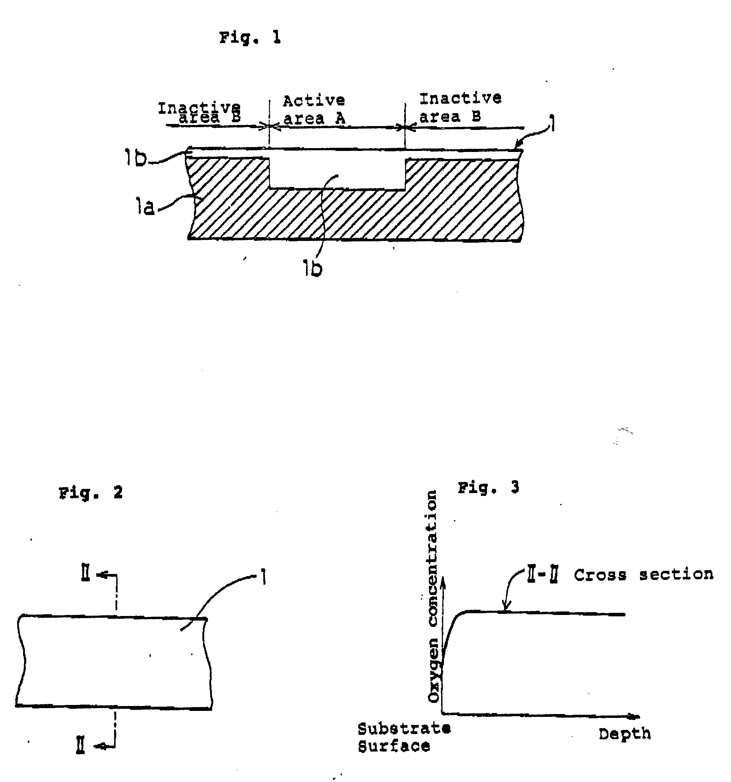

As shown in Figure 1, the semiconductor substrate 1 of this invention has a defect-containing zone 1a in the inside thereof. The defect-containing zone 1a contains crystal defects which have been intentionally formed as in the intrinsic gettering method. In the surface region of the semiconductor substrate 1, there have been formed a defect-free zone 1b which contains few crystal defects. The defect-containing zone 1a is thinner within the active area A, in which semiconductor elements will be later formed, than within the inactive areas B. Therefore, the defect-free zone 1b is thicker within the active area A, than within the inactive areas B.

As mentioned above, the semiconductor elements are formed in the defect-free zone 1b within the active region A, resulting in a semiconductor device of this invention.

The above-mentioned semiconductor substrate 1 is prepared as follows:

As a starting semiconductor substrate, a silicon wafer having high oxygen concentration is used which is supersaturated with oxygen. First of all, the semiconductor substrate 1 shown in Figure 2, is subjected to the first heat treatment. The first heat treatment is conducted at a high temperature for a short period of time, so that oxygen atoms contained in the surface region of the semiconductor substrate 1 are allowed to diffuse outwardly. Figure 3 shows the oxygen concentration distribution in cross section of the semiconductor substrate 1 after the first heat treatment, which cross section is taken on line II-II of Figure 2. As seen from Figure 3, the oxygen concentration in the semiconductor substrate 1 is decreased in the vicinity of the surface thereof. The semiconductor substrate 1 has the same oxygen concentration distribution throughout its entire region as that shown in Figure 3.

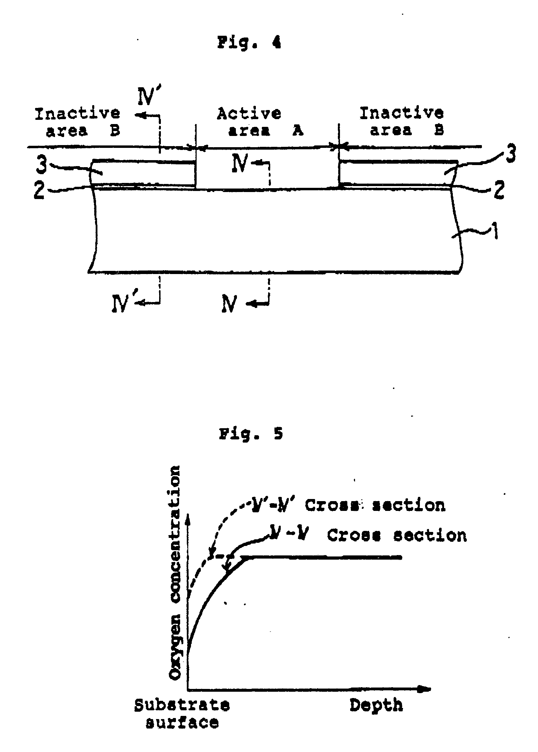

Then, an oxide film 2 (e.g., a film of silicon dioxide (SiO_2)) and a barrier film 3 (e.g., a film of silicon nitride (Si_3N_4)) are successively formed on the entire surface of the semiconductor substrate 1. A portion of these films within the active area A is removed by a photoetching technique as shown in Figure 4. The barrier film 3 will prevent oxygen atoms from diffusing out of the substrate in the later step of conducting the second heat treatment. The semiconductor substrate 1 on which the oxide film 2 and the barrier film 3 have been formed in this way only within the inactive areas B is subjected to the second heat treatment. The second heat treatment is conducted at a high temperature for a long period of time, so that oxygen atoms in the surface region of the semiconductor substrate 1 diffuse outwardly into the deep region of the semiconductor substrate 1. Therefore, the oxygen concentration in cross section of the semiconductor substrate 1 after the second heat treatment, which cross section is taken on line IV-IV of Figure 4, is decreased from the surface down to the deep region of the substrate as shown by a solid line of Figure 5. However, in the inactive areas B within which the semiconductor substrate 1 is coated with the oxide film 2 and the barrier film 3, there is no occurrence of outward diffusion of oxygen atoms. Therefore, the oxygen concentration in cross section taken on line IV'-IV' of Figure 4 is decreased only in the vicinity of the surface of the semiconductor substrate 1 as shown by a broken line of Figure 5.

The semiconductor substrate 1 having the oxygen concentration distribution mentioned above is subjected to the third heat treatment. The third heat treatment is conducted at a low temperature, so that some of the oxygen atoms present in the semiconductor substrate 1 are deposited in their places to form crystal defects. Therefore, after the third heat treatment is completed, the defect-containing zone 1a has been formed in a portion of the semiconductor substrate 1, which portion contains oxygen atoms in high concentration, resulting in the semiconductor substrate 1 shown in Figure 1.

The semiconductor substrate 1 obtained in this way has a defect-free zone 1b of great thickness in the surface region thereof within the active area A, so that semiconductor elements can be formed in the defect-free zone 1b in the same way as in the conventional semiconductor devices, resulting in a semiconductor device of this invention. On the other hand, in the inactive areas B, the defect-containing zone 1a has been formed from the deep region up to the vicinity of the surface of the semiconductor substrate 1, so that it is possible to prevent the generation of undesirable carriers in these areas.

It is understood that various other modifications will be apparent to and can be readily made by those skilled in the art without departing from the scope of this invention as defined by the appended claims.

**Claims**

1. A semiconductor device comprising a semiconductor substrate (1) which has a defect-containing zone (1a) in the inside thereof and a defect-free zone (1b) in the surface region thereof, wherein said defect-free zone (1b) is thinner within inactive areas (B) than within active areas (A).

2. A semiconductor device according to claim 1, wherein semiconductor elements are formed in the defect-free zone (1b) of the substrate within the active areas (A).

3. A semiconductor device according to claim 2, which is selected from the group consisting of charge coupled devices, image sensors, and dynamic random access memories.

Fig. 1

Inactive area B | Active area A | Inactive area B

1

1b

1a

1b

Fig. 2

II

1

II

Fig. 3

Oxygen concentration

II-II Cross section

Substrate Surface

Depth

Fig. 4

Fig. 5